# FASCICULE DE BREVET EUROPEEN

(11) **EP 1 265 352 B1**
(45) Date de publication et mention de la délivrance du brevet: **10.08.2011**
(21) Numéro de dépôt: 01202173.9
(22) Date de dépôt: 07.06.2001
(51) Int. Cl.: H03B 5/32, H03B 5/36

(54) **Circuit oscillateur différentiel comprenant un résonateur électromécanique**
Differenzielle Oszillatorschaltung mit einem elektromechanischen Resonator
Differential oscillator circuit comprising an electromechanical resonator

(43) Date de publication de la demande: 11.12.2002
(73) Titulaire: CSEM Centre Suisse d'Electronique et de Microtechnique S.A. - Recherche et Développement, 2002 Neuchâtel (CH)
(72) Inventeur: Ruffieux, David, 1789 Lugnorre (CH)
(74) Mandataire: GLN

(56) Documents cités:
- EP-A- 0 335 493
- DE-A- 4 331 499
- US-A- 4 588 968
- US-A- 5 469 116
- US-A- 5 999 062

## Description

La présente invention concerne de manière générale un circuit oscillateur différentiel comprenant un résonateur électromécanique, notamment pour une application en tant que garde-temps ou dans le domaine des télécommunications.

Les circuits oscillateurs sont utilisés dans deux catégories principales d'applications. L'une est l'application comme garde-temps ou générateur de signaux d'horloge et l'autre est l'application comme circuit rendant possible la translation en fréquence des signaux dans des dispositifs de télécommunication.

Les résonateurs électromécaniques, tels les résonateurs à quartz, sont utilisés pour ainsi dire systématiquement dans les applications de garde-temps nécessitant une base de temps de précision, alors que les circuits oscillateurs utilisés dans les radio-transmetteurs emploient de manière générale des circuits résonants LC, ou « LC tank circuits » en terminologie anglo-saxonne. Les circuits associés à ces deux types de résonateurs ne sont pas sensiblement différents.

On peut citer à ce titre le document de brevet DE 43 31 399, qui décrit un tel circuit oscillateur qui utilise un circuit résonant du type LC. Chaque inductance est connectée d'une part à une borne de potentiel haut d'une alimentation électrique, et d'autre part sur un terminal de grille d'un transistor FET respectif agissant comme un condensateur dans un montage Darlington. Deux autres transistors FET des montages Darlington en paire différentielle sont reliés en série entre les bornes de potentiel haut et bas de l'alimentation avec une source de courant respective et une résistance. Un condensateur de couplage relie le terminal de source de ces transistors, alors que le terminal de drain relié chacun à une résistance en série définit une borne de sortie du circuit oscillateur. Deux transistors montés en condensateur de compensation relient chacun respectivement le terminal de grille d'un des transistors FET de la paire différentielle au terminal de drain de l'autre transistor FET de la paire différentielle. L'agencement d'un tel circuit oscillateur est prévu pour opérer à haute fréquence.

Dans le document de brevet EP 0 335 493, il est utilisé un résonateur électromécanique, qui est un résonateur à ondes acoustiques de surface (SAW), dans le circuit oscillateur. Pour ce faire, ce circuit oscillateur comprend deux branches connectées chacune entre une borne de potentiel haut et une borne de potentiel bas d'une alimentation électrique. Chaque branche comporte en série une résistance, un transistor et au moins une source de courant, qui peut être commune pour les deux branches. Deux bornes du résonateur SAW, en tant que bornes de sortie, sont reliées aux bornes de drain des transistors. Deux autres bornes du résonateur SAW sont reliées dans une même branche respective au terminal de grille du transistor correspondant. Un tel circuit oscillateur ne peut utiliser qu'un résonateur du type SAW à quatre bornes de connexion pour obtenir un signal oscillant en sortie du circuit oscillateur, ce qui peut constituer un inconvénient.

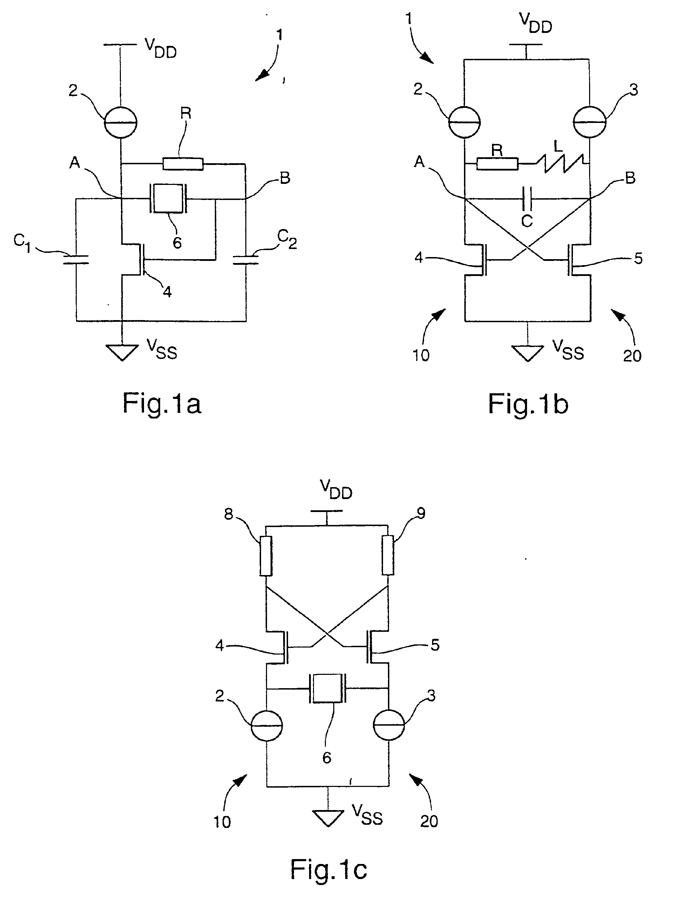

La figure 1a montre un circuit oscillateur basse consommation 1 comportant un résonateur à quartz typiquement utilisé dans des applications comme garde-temps. Ce circuit oscillateur 1, également connu sous la dénomination « circuit oscillateur Colpitts », comporte ainsi une branche comprenant un agencement série, en partant d'un potentiel d'alimentation VDD à un potentiel d'alimentation VSS formant masse, d'une source de courant 2 et d'un transistor MOS 4 connecté par son terminal de drain à la source de courant 2 et par son terminal de source au potentiel VSS. Un résonateur à quartz 6 ainsi qu'un élément résistif R sont connectés en parallèle entre le noeud de connexion, indiqué par la référence A, de la source de courant 2 et du transistor 4, et le noeud de connexion, indiqué par la référence B, relié au terminal de grille du transistor 4. Des premier et second éléments capacitifs de charge C1 et C2 sont respectivement connectés, par l'une de leur électrode, aux noeuds de connexion A et B, l'autre électrode étant reliée au potentiel d'alimentation VSS.

La figure 1b montre une version différentielle d'un circuit oscillateur analogue au circuit de la figure 1a. Dans cet exemple, ce circuit emploie un circuit résonant LC. Ce circuit oscillateur, également indiqué globalement par la référence numérique 1, comporte, placés en parallèle entre les potentiels d'alimentation VDD et VSS, des première et seconde branches 10, 20 comprenant chacune un agencement série d'une source de courant 2, resp. 3, et d'un transistor 4, resp. 5, connecté par son terminal de drain à la source de courant et par son terminal de source au potentiel VSS. Le circuit résonant LC comporte un élément capacitif C placé en parallèle à l'agencement série d'un élément résistif R, symbolisant généralement les pertes de l'agencement, et d'un élément inductif L.

Les transistors 4 et 5 sont connectés en configuration différentielle de manière à former une paire croisée, c'est-à-dire que le terminal de grille de chaque transistor est relié au terminal de drain de l'autre transistor. Le noeud de connexion A est ainsi formé du noeud de connexion entre la source de courant 2, le terminal de drain du transistor 4 et le terminal de grille du transistor 5, et le noeud de connexion B est formé du noeud de connexion entre la source de courant 3, le terminal de drain du transistor 5 et le terminal de grille du transistor 4. Le circuit résonant LC est ainsi placé, de manière similaire au résonateur à quartz de la figure 1a, entre les noeuds de connexion A et B du circuit oscillateur, du côté des terminaux de drain des transistors 4 et 5.

La structure différentielle de la figure 1b offre des avantages substantiels pour des applications à haute fréquence telle, notamment, une sensibilité réduite au bruit d'alimentation et de substrat, un contenu réduit des harmoniques paires et l'injection d'un courant de substrat limité.

Il convient de mentionner que le circuit de la figure 1b ne peut être utilisé en tant que tel avec un résonateur électromécanique, tel un résonateur à quartz, car ce circuit présenterait, dans un tel cas, une instabilité de la composante continue DC, sauf si un chemin de faible valeur ohmique existait à basse fréquence entre les terminaux de drain des transistors tel que dans la configuration du circuit résonant LC parallèle.

Des tentatives de réalisation de circuits oscillateurs différentiels employant un résonateur électromécanique ont été proposées mais n'ont pas pour l'instant conduit à des solutions satisfaisantes, principalement pour des raisons de stabilité. La figure 1c montre par exemple le prototype d'un circuit oscillateur différentiel employant un résonateur à quartz développé pour la première montre électronique suisse.

Ce prototype de circuit comporte deux branches identiques 10, 20 comprenant chacune, en partant du potentiel d'alimentation VDD au potentiel d'alimentation VSS, l'agencement série d'un élément résistif 8, resp. 9, d'un transistor n-MOS 4, resp. 5, et d'une source de courant 2, resp. 3. Le résonateur à quartz 6 est connecté du côté des terminaux de source des transistors 4 et 5 et, de manière analogue au circuit de la figure 1b, les transistors 4 et 5 sont branchés en configuration différentielle, le terminal de grille de chaque transistor étant relié au terminal de drain de l'autre transistor.

Comme déjà mentionné, la réalisation du circuit oscillateur différentiel de la figure 1c n'a pas été menée à terme notamment pour des raisons de stabilité.

Outre les circuits oscillateurs susmentionnés, on notera que les récents développements en matière de fabrication de résonateurs à ondes acoustiques de volume, plus communément connus sous la dénomination anglo-saxonne « bulk acoustic wave resonators » (ou résonateurs BAW), offrent de nouvelles opportunités pour les applications dans les domaines des télécommunications. Les résonateurs électromécaniques BAW, et plus particulièrement les résonateurs BAW en couche minceprésentent des avantages considérables, notamment des fréquences de travail élevées (de l'ordre de 1 à 10 GHz), un haut facteur de qualité, une taille réduite et la possibilité d'être intégrés directement sur le circuit intégré. A titre d'information complémentaire concernant les résonateurs BAW, on pourra se référer au document de MM. K. M. Lakin, K. T. McCarron et R. E. Rose, « Solidly Mounted Resonators and Filters », 1995 IEEE Ultrasonics Symposium, pp. 905-908.

Les possibilités offertes par les résonateurs BAW susmentionnés nécessitent le développement de circuits dédiés faisant usage de tous les avantages et des excellentes propriétés de ces résonateurs.

Un but général de la présente invention est de proposer un circuit oscillateur notamment adapté, mais pas uniquement, aux applications à haute fréquence.

Un autre but de la présente invention est de proposer un tel circuit oscillateur présentant en outre une bonne stabilité.

Un but plus particulier de la présente invention est de proposer un circuit oscillateur pouvant notamment faire usage des avantages et des excellentes propriétés des résonateurs BAW susmentionnés.

La présente invention a donc pour objet un circuit oscillateur différentiel comportant un résonateur électromécanique dont les caractéristiques sont énoncées dans la revendication indépendante 1.

Des modes de réalisation avantageux de la présente invention font l'objet des revendications dépendantes.

Selon l'invention, le circuit oscillateur différentiel comporte en particulier des première et seconde branches comprenant chacune un agencement série d'au moins une première source de courant, d'un transistor connecté par ses terminaux de courant et d'un moyen formant résistance assurant une polarisation adéquate des transistors. Les transistors sont branchés, de manière analogue à l'art antérieur, dans une configuration différentielle, le terminal de commande de chaque transistor étant connecté au terminal de courant de l'autre transistor présentant le potentiel le plus positif, tel le terminal de drain des transistors dans le cas où ceux-ci sont réalisés en technologie MOS.

Plus particulièrement, selon l'invention, le résonateur électromécanique est connecté entre les terminaux de commande des transistors, à savoir du côté des terminaux de courant des transistors présentant le potentiel le plus positif, tels les terminaux de drain des transistors en technologie MOS. En outre, un élément capacitif est placé entre les terminaux de courant des transistors présentant le potentiel le plus négatif, à savoir les terminaux de source des transistors MOS.

Les divers modes de réalisation qui seront décrits dans la suite de la description sont basés sur une technologie MOS. Bien que non explicitement représentées, les versions duales de ces modes de réalisation (obtenues par inversion des tensions d'alimentation et des polarités des transistors) sont réputées comme faisant également partie de l'invention. Par ailleurs, on comprendra de même que la présente invention n'est pas limitée à cette technologie spécifique et que les transistors pourraient, le cas échéant, être réalisés en technologie bipolaire.

L'invention propose pour la première fois une solution efficace faisant appel à un circuit oscillateur à structure différentielle comprenant un résonateur électromécanique. A la différence du circuit oscillateur de la figure 1c qui présente un problème de stabilité, le circuit oscillateur selon la présente invention présente une grande stabilité et se comporte essentiellement comme le circuit oscillateur de la figure 1b au voisinage de la fréquence de résonance du circuit résonant LC. L'élément capacitif placé du côté source par rapport à la paire croisée de transistors fixe la fréquence en dessous de laquelle la stabilisation de la composante continue DC - ou contre-réaction négative - domine, et en dessus de laquelle les oscillations ont lieu.

Selon l'invention, les sources de courant peuvent réguler les amplitudes d'oscillation si elles sont placées dans une boucle de réglage basse fréquence suivant un détecteur d'amplitude.

Du point de vue de la consommation, le circuit oscillateur selon la présente invention présente de meilleures performances que l'oscillateur Colpitts illustré dans la figure 1a, car les éléments capacitifs de charge C1 et C2 placés de part et d'autre du résonateur Colpitts sont supprimés, selon la présente invention, sans que cela ne modifie le comportement du circuit et que cela ne soit néfaste pour la stabilité en fréquence de cet oscillateur.

D'autres caractéristiques et avantages de la présente invention apparaîtront plus clairement à la lecture de la description détaillée qui suit, faite en référence aux dessins annexés donnés à titre d'exemples non limitatifs et dans lesquels :
- la figure 1a, déjà présentée, montre un schéma d'un circuit oscillateur à résonateur électromécanique connu sous le nom de Colpitts ;
- la figure 1b, déjà présentée, montre un schéma d'un circuit oscillateur différentiel comportant un circuit résonant LC ;

- la figure 1c, déjà présentée, montre un schéma d'un prototype d'un circuit oscillateur différentiel comportant un résonateur électromécanique envisagé pour la première montre électronique suisse ;
- la figure 2 montre un circuit oscillateur différentiel constituant un premier mode de réalisation de la présente invention ;
- la figure 3 montre un circuit oscillateur différentiel constituant un second mode de réalisation de la présente invention ;
- la figure 4 montre un schéma d'un circuit comportant un circuit oscillateur différentiel selon le second mode de réalisation de la présente invention équipé d'une boucle de réglage en amplitude ainsi que le premier étage d'un circuit diviseur préalable, ou prescaler, permettant notamment de produire des signaux I, Q en quadrature de phase ;
- la figure 5 montre un circuit oscillateur différentiel constituant un troisième mode de réalisation de la présente invention ; et
- les figures 6a et 6b montrent deux variantes du troisième mode de réalisation de la présente invention équipées de moyens d'atténuation capacitifs placés sur la paire croisée de transistors permettant une linéarisation des caractéristiques de ces transistors.

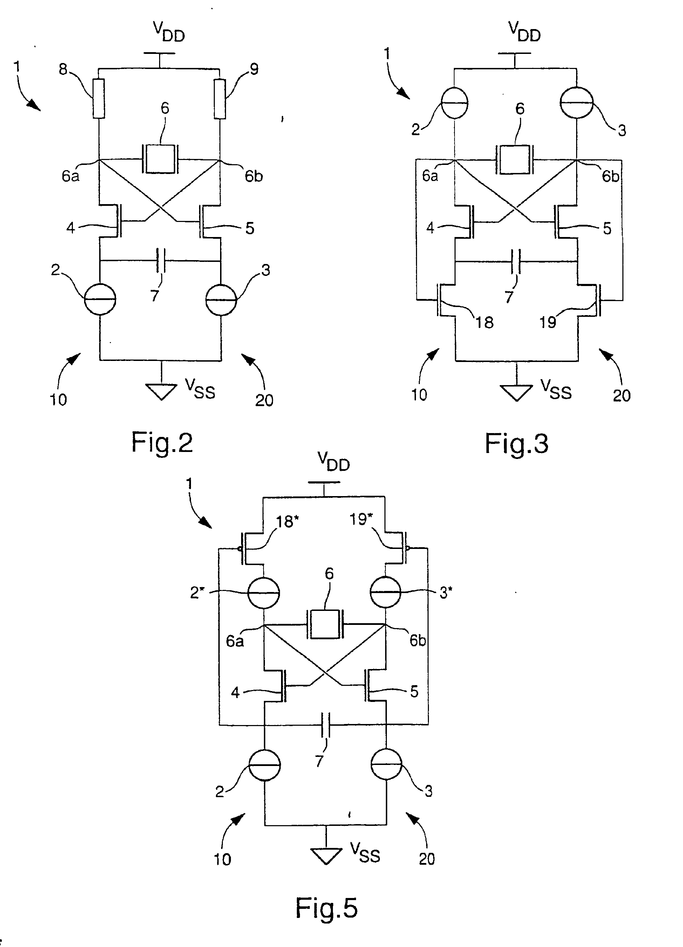

La figure 2 montre un schéma d'un circuit oscillateur différentiel, indiqué globalement par la référence numérique 1, constituant un premier mode de réalisation de la présente invention.

Ce circuit oscillateur différentiel 1 comprend de manière générale des première et seconde branches, respectivement désignées par les références numériques 10 et 20, connectées chacune entre un potentiel d'alimentation haut VDD et un potentiel d'alimentation bas VSS. Ces branches sont identiques et comprennent chacune, en partant du potentiel d'alimentation haut VDD, l'agencement série d'un élément résistif 8, resp. 9, d'un transistor n-MOS 4, resp. 5, et d'une source de courant 2, resp. 3. Plus spécifiquement, les éléments résistifs 8, 9 sont connectés entre le potentiel d'alimentation VDD et le drain du transistor 4, pour l'un, et le drain du transistor 5, pour l'autre. De même, les sources de courant 2, 3 sont connectées entre le potentiel d'alimentation VSS et la source du transistor 4, pour l'un, et la source du transistor 5, pour l'autre.

Les transistors 4, 5 forment une paire croisée de transistors. Dans cette configuration, le drain du transistor 4 de la première branche 10 est relié à la grille du transistor 5 de l'autre branche 20, et, par symétrie, le drain du transistor 5 de la seconde branche 20 est relié à la grille du transistor 4 de la première branche 10.

Selon l'invention, le circuit oscillateur différentiel 1 comporte en outre un résonateur électromécanique 6 connecté par des première et seconde bornes 6a, 6b entre les drains des transistors 4 et 5 des deux branches 10, 20. Ces première et seconde bornes 6a, 6b du résonateur électromécanique 6 forment par ailleurs les première et seconde bornes de sortie du circuit oscillateur différentiel.

Ce résonateur électromécanique 6 peut être un résonateur à quartz à impédance élevée en régime continu ou, dans l'optique d'une utilisation pour des applications à hautes fréquences (dans une gamme de l'ordre de 1 à 10 GHz), avantageusement un résonateur à ondes acoustiques de volume tels les résonateurs BAW mentionnés en préambule ou, encore, les résonateurs dits « TFBAR » (« Thin Film Bulk Acoustic Resonators »).

Le circuit oscillateur différentiel 1 selon l'invention comporte par ailleurs un élément capacitif 7 connecté entre les sources des transistors 4, 5. Cet élément capacitif 7 fixe la fréquence en-dessous de laquelle la stabilisation DC (ou contre-réaction négative) domine et en-dessus de laquelle les oscillations peuvent avoir lieu.

D'une manière générale, et comme on le verra plus en détail ci-après en rapport au second mode de réalisation de la présente invention, les sources de courant 2, 3 peuvent permettre la régulation de l'amplitude des oscillations si ces dernières sont placées dans une boucle de réglage en amplitude adéquate.

Comme déjà mentionné en préambule, la structure illustrée dans la figure 2 (ainsi que les structures qui seront discutées ci-après en référence aux figures 3 et 5) sont plus performantes en terme de consommation que le circuit oscillateur Colpitts illustré dans la figure 1a. En effet, on peut s'affranchir de l'utilisation des éléments capacitifs de charge présents de part et d'autre du résonateur électromécanique sans altérer le comportement ou la stabilité en fréquence de cet oscillateur.

La figure 3 montre un schéma d'un circuit oscillateur différentiel, indiqué également par la référence numérique 1, constituant un second mode de réalisation de la présente invention. Les éléments communs à ce mode de réalisation et au mode de réalisation précédent sont indiqués par les mêmes références numériques.

De manière analogue au circuit de la figure 2, ce circuit oscillateur différentiel comporte deux branches 10, 20 identiques comprenant chacune l'agencement série, entre les potentiels VDD et VSS, d'une source de courant 2, 3, d'un transistor n-MOS 4, 5 et d'un moyen formant résistance (transistors 18 et 19).

Le résonateur électromécanique 6 et l'élément capacitif 7 sont connectés comme précédemment de part et d'autre de la paire croisée de transistor 4, 5, le résonateur 6 du côté drain et l'élément capacitif 7 du côté source.

La structure de la figure 3 diffère du premier mode de réalisation de la figure 2 en ce que les sources de courant 2, 3 sont connectées entre le potentiel d'alimentation VDD et les drains des transistors 4, 5 de la paire croisée. Les moyens formant résistances sont formés chacun d'un transistor n-MOS 18, 19 connecté par son drain à la source du transistor correspondant de la paire croisée 4, 5, et par sa source au potentiel d'alimentation VSS. Les grilles de ces transistors 18, 19 sont respectivement connectées sur les drains des transistors 4, 5 de la paire croisée. On comprendra que les transistors 18, 19 se comportent ainsi comme des résistances variables dont les valeurs sont commandées par la tension présente au niveau des drains des transistors de la paire croisée. Fonctionnellement, ces transistors 18, 19 jouent un rôle analogue au rôle rempli par les éléments résistifs 8 et 9 du mode de réalisation de la figure 2.

La structure du circuit oscillateur de la figure 3 est toutefois plus avantageuse que la structure illustrée dans la figure 2 en ce sens qu'elle ne nécessite pas l'utilisation des éléments résistifs précédents pour assurer la polarisation adéquate des transistors. En conséquence, cette structure peut être opérée à une tension plus faible et est moins sensible au bruit d'alimentation. En outre, la tension de mode commun de ce transistor ne dépend pas sensiblement du courant traversant les transistors, le temps de démarrage peut être réduit et la tension d'offset, résultant de la disparité (« mismatch ») des transistors, aux bornes du résonateur peut être abaissée.

Comme on le verra maintenant, un autre avantage de la structure du circuit oscillateur de la figure 3 réside dans le fait qu'une boucle de réglage en amplitude peut aisément être conçue et dans le fait qu'un circuit diviseur préalable, aussi dénommé prescaler, ayant le même mode commun peut être utilisé pour réaliser les premiers étages de division de l'oscillateur.

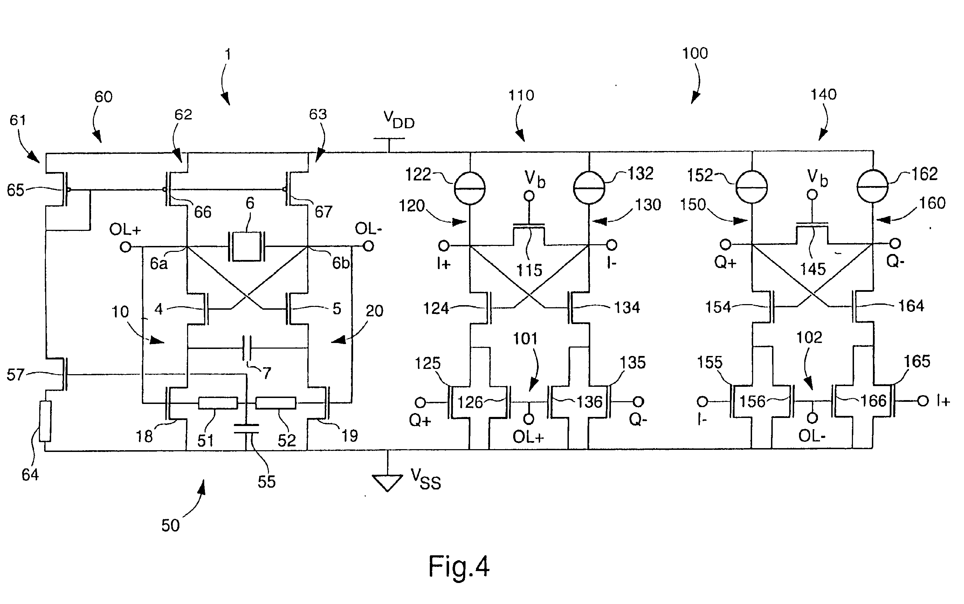

La figure 4 décrit ainsi un schéma d'un oscillateur complet basé sur le second mode de réalisation de la figure 3 et comprenant en complément une boucle de réglage de l'amplitude des oscillations ainsi que le premier étage d'un circuit diviseur préalable, ou prescaler, permettant notamment de produire des signaux I, Q en quadrature de phase. Ce circuit est en particulier destiné à une application dans le domaine des télécommunications.

La boucle de réglage en amplitude, désignée globalement par la référence numérique 50, est reliée à chacune des bornes 6a, 6b du résonateur électromécanique 6 et délivre un signal permettant d'asservir le courant des sources de courant 2, 3 des deux branches 10, 20 du circuit oscillateur 1. Ces sources de courant sont réalisées de manière conventionnelle au moyen d'un miroir de courant, désigné 60, comprenant, dans cet exemple, une branche de référence 61 comportant un élément résistif 64 en série avec un premier transistor p-MOS 65 dont la grille et le drain sont reliés entre eux, et deux branches de sortie 62, 63 connectées aux première et seconde branches 10 et 20 du circuit oscillateur 1 et comportant chacune un transistor p-MOS 66, 67 connecté au drain du transistor correspondant de la paire croisée de transistors 4, 5.

Plus spécifiquement, la boucle de réglage comporte notamment deux éléments résistifs 51, 52 branchés en série entre les bornes 6a, 6b du résonateur 6 et un élément capacitif 55 branché entre le noeud de connexion des éléments résistifs 51, 52 et le potentiel d'alimentation bas VSS. La tension présente au noeud de connexion des éléments résistifs 51, 52 est appliquée sur la grille d'un transistor n-MOS 57 branché par ses terminaux de source et de drain, dans cet exemple, entre l'élément résistif 64 et le transistor p-MOS 65 de la branche de référence 61 du miroir de courant.

Ainsi, l'amplitude d'oscillation, dont dépend la tension de mode commun de l'oscillateur, est extraite au moyen des éléments résistifs 51, 52 pour polariser le transistor 57 qui détermine le courant traversant la branche de référence 61 du miroir de courant et dont les images sont reproduites dans les branches 10 et 20 du circuit oscillateur 1. De la sorte, dès lors que l'amplitude d'oscillation augmente, le courant traversant chaque branche de l'oscillateur est diminué jusqu'à ce qu'un point stable soit atteint.

Pour une implémentation à faible fréquence, inférieure à quelques dizaines de MHz, les deux éléments résistifs 51, 52 utilisés pour extraire la tension de mode commun peuvent être réalisées au moyen de quatre diodes poly dos-à-dos, ou de transistors MOS en conduction, de sorte que leur conductance reste bien inférieure à la conductance parallèle équivalente du résonateur électromécanique 6. Dans un tel cas, le pôle du filtre n'est pas bien sous contrôle de sorte que cette solution devrait être écartée dans le cas où l'oscillateur, utilisé comme oscillateur de référence dans un émetteur et/ou récepteur radio-fréquence, est activé et désactivé par intermittence afin d'économiser de l'énergie. Dans les architectures conventionnellement rencontrées, la base de temps est généralement équipée d'un résonateur à quartz basse fréquence (typiquement 32 kHz) fonctionnant en permanence et consommant nettement moins que l'oscillateur radio de référence. L'amélioration en terme de consommation attendue avec le circuit oscillateur différentiel selon la présente invention permettrait avantageusement la suppression de ce résonateur à quartz 32 kHz, et, pour conséquence, des coûts de fabrication réduits ainsi que de meilleures performances.

Le premier étage du circuit diviseur préalable est indiqué globalement par la référence numérique 100 et comprend deux structures identiques interconnectées 110 et 140 très similaires à la structure du circuit oscillateur différentiel 1 présenté plus haut. Cet agencement forme un circuit oscillateur à relaxation. Ce premier étage 100 comporte deux entrées 101 et 102 sur lesquelles sont connectées les bornes de sorties 6a, 6b du circuit oscillateur différentiel 1. De manière générale, les entrées 101, 102 du diviseur synchronisent l'oscillateur à relaxation en verrouillant alternativement chacune des structures 110, 140 durant la moitié d'une période d'oscillation.

Plus spécifiquement, chaque structure 110, 140 comporte deux branches identiques 120, 130 et 150, 160 connectées chacune entre les potentiels d'alimentation haut VDD et bas VSS. Chaque branche comporte l'agencement série, en partant du potentiel d'alimentation VDD, d'une source de courant 122, 132, 152, 162, d'un premier transistor n-MOS 124, 134, 154, 164 connecté par son terminal de drain à la source de courant, et de second et troisième transistors n-MOS 125, 135, 155, 165, respectivement 126, 136, 156, 166, tous deux connectés par leur terminal de drain au terminal de source du premier transistor et par leur terminal de source au potentiel d'alimentation bas VSS.

Dans chaque structure, les premiers transistors 124 et 134, respectivement 154 et 164, sont connectés en configuration différentielle pour former une paire croisée de manière similaire au circuit oscillateur différentiel 1, le terminal de grille de chacun de ces transistors étant ainsi connecté au terminal de drain de l'autre transistor de la paire croisée.

D'autre part, les terminaux de grille des troisièmes transistors 126 et 136, respectivement 156 et 166, de chaque structure 110, 140 sont connectés l'un à l'autre et forment respectivement la première 101 et la seconde 102 bornes d'entrée du circuit diviseur préalable 100.

Le circuit diviseur préalable délivre en sortie des signaux en quadrature de phase désignés I+, I-, Q+, Q-, où I- et Q- désignent respectivement les inverses des signaux en quadrature de phase I+ et Q+. Plus particulièrement, les signaux I+ et Q+ sont respectivement délivrés sur le terminal de drain du transistor 124 de la première branche 120 de la première structure 110 et sur le terminal de drain du transistor 154 de la première branche 150 de la seconde structure 140. Leur inverse I- et Q- sont délivrés sur le terminal de drain de l'autre transistor de la paire croisée correspondante.

Les deux structures 110 et 140 sont en outre interconnectées de sorte que le signal I+ et son inverse I-, délivrés sur les terminaux de drain des transistors 124, 134 de la première structure 110, sont respectivement appliqués sur les terminaux de grille des transistors 165 et 155 de la seconde structure 140, à savoir le signal I+ sur la grille du transistor 165 et le signal I-sur la grille du transistor 155. De même, le signal Q+ et son inverse Q-, délivrés sur les terminaux de drain des transistors 154 et 164 de la seconde structure 140, sont respectivement appliqués sur les grilles des transistors 125 et 135 de la première structure 110. Par souci de simplification, ces interconnexions n'ont pas été représentées dans la figure 4, celles-ci étant simplement identifiées par la référence du signal appliqué sur les terminaux concernés. Il en va d'ailleurs de même pour l'interconnexion entre les bornes de sortie 6a, 6b du circuit oscillateur différentiel 1 qui sont appliquées sur les bornes d'entrées 101, 102 du circuit diviseur préalable 100, cette interconnexion étant identifiée par les références OL+ et OL-.

Chaque structure 110, 140 comporte en outre un quatrième transistor 115, respectivement 145 connecté par ses terminaux de source et de drain entre les terminaux de drain des transistors de la paire croisée. La tension Vb appliquée sur le terminal de grille de ce quatrième transistor fixe l'amplitude de sortie des signaux en quadrature de phases. Cette tension Vb permet de réduire l'amplitude d'oscillation et ainsi réduire considérablement la consommation, cette amplitude pouvant être graduellement augmentée au fil des étages pour que l'amplitude des signaux atteigne les niveaux de rails après un certain nombre d'étages afin d'assurer un couplage adéquat à des circuits diviseurs logiques conventionnels. Selon une variante de réalisation, les transistors 115 et 145 sont remplacés par des résistances fixes.

De manière générale, grâce à la structure de l'oscillateur et du diviseur, tous les étages peuvent être couplés directement car le mode commun de sortie de chaque étage est utilisé comme polarisation à l'entrée de l'étage suivant.

La figure 5 montre un schéma d'un circuit oscillateur différentiel, indiqué également par la référence numérique 1, constituant un troisième mode de réalisation de la présente invention. Les éléments communs à ce mode de réalisation et aux modes de réalisation précédents sont indiqués par les mêmes références numériques.

De manière analogue aux modes de réalisation précédents, ce circuit oscillateur différentiel comporte deux branches 10, 20 identiques comprenant chacune l'agencement série, entre les potentiels VDD et VSS, d'une source de courant 2, 3, d'un transistor n-MOS 4, 5 et d'un moyen formant résistance (transistors 18* et 19*). La disposition du résonateur électromécanique 6, de l'élément capacitif 7 et des transistors 4, 5 formant la paire croisée reste à nouveau inchangée.

La structure de la figure 5 diffère du second mode de réalisation de la figure 3, d'abord, en ce que les sources de courant 2, 3 sont connectées entre le potentiel d'alimentation VSS et les sources des transistors 4, 5 de la paire croisée. Les moyens formant résistances sont constitués chacun d'un transistor p-MOS 18*, 19* connecté, par son drain (via une source de courant additionnelle 2*, 3*) au drain du transistor correspondant de la paire croisée et, par sa source au potentiel d'alimentation VDD. Les grilles de ces transistors 18*, 19* sont respectivement connectées sur les sources des transistors 4, 5 de la paire croisée. Leur rôle est analogue au rôle rempli par les transistors n-MOS 18 et 19 du mode de réalisation de la figure 3. Enfin, une source de courant additionnelle 2*, respectivement 3*, est connectée entre le noeud de sortie 6a, respectivement 6b, et le drain du transistor p-MOS 18*, respectivement 19*.

Au titre de variante, les grilles des transistors 18*, 19* peuvent alternativement être connectées aux drains des transistors 4, 5 de la paire croisée. Ce branchement se ferait néanmoins au détriment d'une augmentation de la tension d'alimentation minimale.

Encore au titre de variante avantageuse, le circuit oscillateur différentiel de la figure 5 peut être équipé de moyens d'atténuation capacitifs assurant une linéarisation des transistors de la paire croisée.

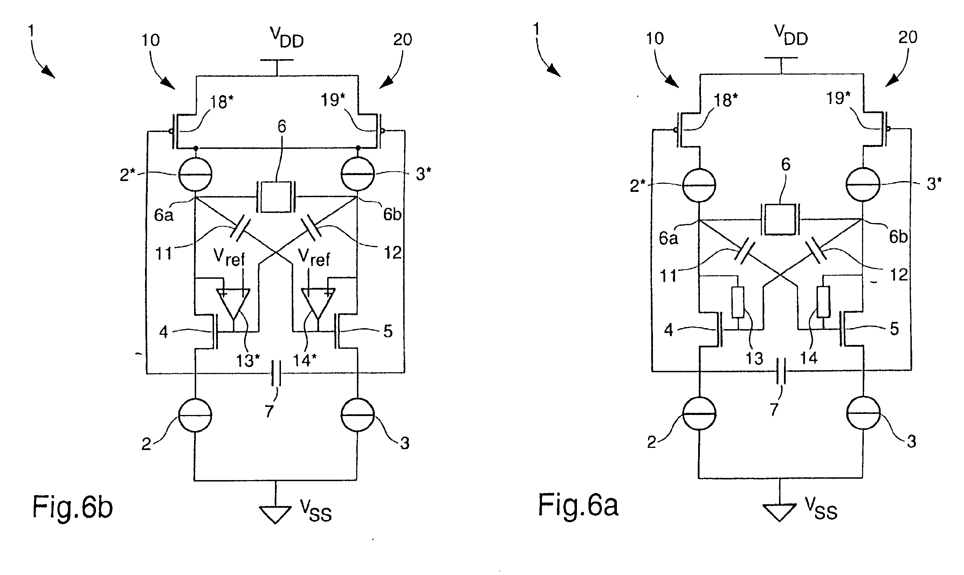

Les figures 6a et 6b illustrent ainsi deux variantes du circuit oscillateur différentiel de la figure 5 équipées de moyens d'atténuation capacitifs placés sur la paire croisée de transistors.

La figure 6a montre une première variante dans laquelle deux éléments capacitifs 11, 12 sont respectivement disposés sur la connexion drain-grille des transistors 4, 5 de la paire croisée, à savoir entre le terminal de grille du transistor 4 et le terminal de drain du transistor 5, et entre le terminal de grille du transistor 5 et le terminal de drain du transistor 4.

Selon cette première variante, la polarisation de la grille des transistors 4, 5 de la paire croisée est assurée par un simple élément résistif 13, respectivement 14, connecté entre les terminaux de drain et de grille du même transistor de la paire croisée comme illustré.

La figure 6b montre une seconde variante plus avantageuse dans laquelle chaque élément résistif 13, 14 est remplacé par un amplificateur 13*, 14* dont l'entrée positive est reliée au terminal de drain du transistor 4, resp. 5, de la paire croisée, la sortie de cet amplificateur étant appliquée sur le terminal de grille du transistor correspondant. L'autre entrée, négative, de l'amplificateur 13*, 14* est fixée à une tension de référence Vref. De la sorte, la tension de drain des transistors 4, 5 de la paire croisée prendra la valeur de l'autre entrée de l'amplificateur, à savoir la tension Vref, indépendamment de la tension de grille du transistor qui est ajustée par l'amplificateur. Par ailleurs dans cette seconde variante, les drains des transistors p-MOS 18* et 19* sont reliés entre eux.

On comprendra que diverses modifications et/ou améliorations évidentes pour l'homme du métier peuvent être apportées au mode de réalisation décrit dans la présente description sans sortir du cadre de l'invention défini par les revendications annexées. Ainsi, comme déjà mentionné, le circuit oscillateur différentiel selon la présente invention pourrait parfaitement être réalisé en technologie bipolaire.

## Revendications

1. Circuit oscillateur différentiel comprenant des première (10) et seconde (20) branches connectées chacune entre un potentiel d'alimentation haut (VDD) et un potentiel d'alimentation bas (VSS), chaque branche (10, 20) comportant, agencés en série :
- un premier transistor (4, 5) présentant un terminal de commande, un premier terminal de courant placé du côté dudit potentiel d'alimentation haut (VDD) et un second terminal de courant placé du côté dudit potentiel d'alimentation bas (VSS) ;
- au moins une première source de courant (2, 3) connectée à l'un desdits terminaux de courant du transistor (4, 5) ;
- chaque branche comporte en outre un moyen formant résistance (8, 9; 18, 19 ; 18*, 19*) connecté à l'un desdits terminaux de courant du transistor (4, 5),
lesdits premiers transistors (4, 5) desdites première et seconde branches (10, 20) étant branchés en configuration différentielle, le premier terminal de courant du premier transistor (4 ; 5) de ladite première branche (10), respectivement de ladite seconde branche (20), étant relié au terminal de commande du premier transistor (5 ; 4) de ladite seconde branche (20), respectivement de ladite première branche (10), et un élément capacitif (7) connecté entre les seconds terminaux de courant des premiers transistors (4, 5) desdites première et seconde branches (10, 20).
**caractérisé en ce que** ce circuit oscillateur différentiel comporte en outre :
- un résonateur électromécanique (6) à ondes de volume, tel qu'un résonateur à quartz, ledit résonateur étant connecté uniquement par des première et seconde bornes (6a, 6b) entre les premiers terminaux de courant des premiers transistors (4, 5) desdites première et seconde branches (10, 20), lesdites première et seconde bornes (6a, 6b) du résonateur électromécanique (6) formant des première et seconde bornes de sortie du circuit oscillateur différentiel.

2. Circuit oscillateur différentiel selon la revendication 1, **caractérisé en ce que** ladite première source de courant (2, 3) de chaque branche (10, 20) est connectée entre le second terminal de courant dudit premier transistor (4, 5) et ledit potentiel d'alimentation bas (VSS),
et **en ce que** ledit moyen formant résistance est un élément résistif (8, 9) connecté entre le premier terminal de courant dudit premier transistor (4, 5) et ledit potentiel d'alimentation haut (VDD).

3. Circuit oscillateur différentiel selon la revendication 1, **caractérisé en ce que** ladite première source de courant (2, 3) de chaque branche (10, 20) est connectée entre le second terminal de courant dudit premier transistor (4, 5) et ledit potentiel d'alimentation bas (VSS),
et **en ce que** ledit moyen formant résistance est un second transistor (18*, 19*) présentant un terminal de commande, un premier terminal de courant et un second terminal de courant respectivement reliés au premier terminal de courant dudit premier transistor (4, 5) à travers une seconde source de courant (2*, 3*) ou au second terminal de courant dudit premier transistor (4, 5), au dit potentiel d'alimentation haut (VDD) et au premier terminal de courant dudit premier transistor (4, 5) à travers ladite seconde source de courant (2*, 3*).

4. Circuit oscillateur différentiel selon la revendication 1, **caractérisé en ce que** ladite première source de courant (2, 3) de chaque branche (10, 20) est connectée entre le premier terminal de courant dudit premier transistor (4, 5) et ledit potentiel d'alimentation haut (VDD),
et **en ce que** ledit moyen formant résistance est un second transistor (18, 19) présentant un terminal de commande, un premier terminal de courant (18a, 19a) et un second terminal de courant respectivement reliés au premier terminal de courant dudit premier transistor (4, 5), au second terminal de courant dudit premier transistor (4, 5) et au dit potentiel d'alimentation bas (VSS).

5. Circuit oscillateur différentiel selon la revendication 4, **caractérisé en ce qu'**il comporte en outre une boucle de réglage en amplitude (50) reliée aux bornes dudit résonateur électromécanique (6) pour asservir le courant délivré par les premières sources de courant (2, 3) desdites première et seconde branches (10, 20),
cette boucle de réglage en amplitude (50) comprenant deux éléments résistifs (51, 52) branchés en série entre les bornes dudit résonateur électromécanique (6) et un élément capacitif (55) branché entre le noeud de connexion desdits éléments résistifs (51, 52) et ledit potentiel d'alimentation bas (VSS), la tension présente au noeud de connexion desdits éléments résistifs (51, 52) commandant un moyen de réglage (65) du courant délivré par les premières sources de courant (2, 3) desdites première et seconde branches (10, 20).

6. Circuit oscillateur différentiel selon la revendication 5, **caractérisé en ce que** lesdites premières sources de courant (2, 3) sont réalisées à l'aide d'un miroir de courant (60) comprenant une branche de référence (61) et des première et seconde branches de sortie (61, 62) respectivement reliées aux dites première et seconde branches (10, 20) du circuit oscillateur,
et **en ce que** ledit moyen de réglage (57) est un transistor branché en série par ses terminaux de courant dans ladite branche de référence (61) du miroir de courant (60) et dont le terminal de commande est relié au dit noeud de connexion desdits éléments résistifs (51, 52).

7. Circuit oscillateur différentiel selon la revendication 3, **caractérisé en ce que** le terminal de commande du premier transistor (4 ; 5) de ladite première branche (10), respectivement de ladite seconde branche (20), est relié au premier terminal de courant du premier transistor (5 ; 4) de ladite seconde branche (20), respectivement de ladite première branche (10), au moyen d'un élément capacitif (11, 12),
et **en ce que** chaque branche (10, 20) dudit circuit oscillateur différentiel comporte en outre un élément résistif (13, 14) relié entre le premier terminal de courant et le terminal de commande dudit premier transistor (4, 5).

8. Circuit oscillateur différentiel selon la revendication 3, **caractérisé en ce que** le terminal de commande du premier transistor (4 ; 5) de ladite première branche (10), respectivement de ladite seconde branche (20), est relié au premier terminal de courant du premier transistor (5 ; 4) de ladite seconde branche (20), respectivement de ladite première branche (10), au moyen d'un élément capacitif (11, 12),
et **en ce que** chaque branche (10, 20) dudit circuit oscillateur différentiel comporte en outre un amplificateur (13*, 14*) comportant des première et seconde bornes d'entrée reliées respectivement au premier terminal de courant dudit premier transistor (4, 5) et à une tension de référence (Vref), la sortie dudit amplificateur (13*, 14*) étant appliquée sur le terminal de commande dudit premier transistor (4, 5).

9. Circuit oscillateur différentiel selon l'une quelconque des revendications précédentes, **caractérisé en ce que** ledit résonateur électromécanique (6) est un résonateur à impédance élevée en régime continu.

10. Circuit oscillateur différentiel selon l'une quelconque des revendications précédentes, **caractérisé en ce que** ledit résonateur électromécanique (6) est un résonateur à ondes acoustiques de volume.

## Claims

1. A differential oscillator circuit comprising first (10) and second (20) branches each connected between a high supply potential (VDD) and a low supply potential (VSS), each branch (10, 20) including, arranged serially:
- a first transistor (4, 5) having a control terminal, a first current terminal placed on the side of the high supply potential (VDD) and a second current terminal placed on the side of the low supply potential (VSS);
- at least one first current source (2, 3) connected to one of said current terminals of the transistor (4, 5);
- each branch also includes a means forming a resistance (8, 9; 18, 19; 18*, 19*) connected to one of said current terminals of the transistor (4, 5),
said first transistors (4, 5) of said first and second branches (10, 20) being connected in a differential configuration, the first current terminal of the first transistor (4; 5) of said first branch (10), second branch (20), respectively, being connected to the control terminal of the first transistor (5; 4) of said second branch (20), the first branch (10), respectively, and
- a capacitive element (7) connected between the second current terminals of the first transistors (4, 5) of said first and second branches (10, 20),
**characterized in that** the differential oscillator circuit also includes:
- a volume wave electromechanical resonator (6), such as a quartz resonator, said resonator being connected only by first and second terminals (6a, 6b) between the first current terminals of the first transistors (4, 5) of said first and second branches (10, 20), said first and second terminals (6a, 6b) of the electromechanical resonator (6) forming first and second output terminals of the differential oscillator circuit.

2. The differential oscillator circuit according to claim 1, **characterized in that** said first current source (2, 3) of each branch (10, 20) is connected between the second current terminal of said first transistor (4, 5) and said low supply potential (VSS), and **in that** said means forming the resistance is a resistive element (8, 9) connected between the first current terminal of said first transistor (4, 5) and said high supply potential (VDD).

3. The differential oscillator circuit according to claim 1, **characterized in that** said first current source (2, 3) of each branch (10, 20) is connected between the second current terminal of said first transistor (4, 5) and said low supply potential (VSS),
and **in that** the means forming the resistance is a second transistor (18*, 19*) having a control terminal, a first current terminal and a second current terminal respectively connected to the first current terminal of said first transistor (4, 5) through a second current source (2*, 3*) or to the second current terminal of said first transistor (4, 5), said high supply potential (VDD), and the first current terminal of said first transistor (4, 5) through said second current source (2*, 3*).

4. The differential oscillator circuit according to claim 1, **characterized in that** said first current source (2, 3) of each branch (10, 20) is connected between the first current terminal of said first transistor (4, 5) and said high supply potential (VDD),
and **in that** said means forming the resistance is a second transistor (18, 19) having a control terminal, a first current terminal (18a, 19a), and a second current terminal respectively connected to the first current terminal of said first transistor (4, 5), the second current terminal of said first transistor (4, 5), and said low supply potential (VSS).

5. The differential oscillator circuit according to claim 4, **characterized in that** it also includes an amplitude adjusting loop (50) connected to the terminals of said electromechanical resonator (6) to enslave the current delivered by the first current sources (2, 3) of said first and second branches (10, 20),
this amplitude adjusting loop (50) comprising two resistive elements (51, 52) serially connected between the terminals of said electromechanical resonator (6) and a capacitive element (55) connected between the connection node of said resistive elements (51, 52) and said low supply potential (VSS), the voltage at the connection node of said resistive elements (51, 52) controlling a means (65) for adjusting the current delivered by the first current sources (2, 3) of said first and second branches (10, 20).

6. The differential oscillator circuit according to claim 5, **characterized in that** said first current sources (2, 3) are made using a current mirror (60) comprising a reference branch (61) and first and second output branches (61, 62) respectively connected to said first and second branches (10, 20) of the oscillator circuit,
and **in that** said adjusting means (57) is a transistor serially connected by its current terminals in said reference branch (61) of the current mirror (60) and the control terminal of which is connected to said connecting node of said resistive elements (51, 52).

7. The differential oscillator circuit according to claim 3, **characterized in that** the control terminal of the first transistor (4; 5) of said first branch (10), said second branch (20), respectively, is connected to the first current terminal of the first transistor (5; 4) of said second branch (20), said first branch (10), respectively, using a capacitive element (11, 12),
and **in that** each branch (10, 20) of said differential oscillator circuit also includes a resistive element (13, 14) connected between the first current terminal and the control terminal of said first transistor (4, 5).

8. The differential oscillator circuit according to claim 3, **characterized in that** the control terminal of the first transistor (4; 5) of said first branch (10), said second branch (20), respectively, is connected to the first current terminal of the first transistor (5; 4) of said second branch (20), said first branch (10), respectively, using a capacitive element (11, 12),
and **in that** each branch (10, 20) of said differential oscillator circuit also includes an amplifier (13*, 14*) including first and second input terminals connected to the first current terminal of said first transistor (4, 5) and at a reference voltage (Vref), the output of said amplifier (13*, 14*) being applied on the control terminal of said first transistor (4, 5), respectively.

9. The differential oscillator circuit according to any one of the preceding claims, **characterized in that** said electromechanical resonator (6) is a high impedance resonator in a continuous mode.

10. The differential oscillator circuit according to any one of the preceding claims, **characterized in that** said electromechanical resonator (6) is an acoustic volume wave resonator.

## Patentansprüche

1. Differentialoszillatorkreis, der eine erste (10) und zweite (20) Abzweigung umfasst, wobei jede zwischen einem hohem Versorgungspotential (VDD) und einem niedrigen Versorgungspotential (VSS) verbunden ist, wobei jede Abzweigung (10, 20) in Reihe angeordnet umfasst:
- einen ein Steuerterminal aufweisenden ersten Transistor (4, 5), ein erstes, auf der Seite des hohen Versorgungspotentials (VDD) platziertes Stromterminal und ein zweites, auf der Seite des niedrigen Versorgungspotentials (VSS) platziertes Stromterminal,
- mindestens eine erste Stromquelle (2, 3), die mit einem der Stromterminals des Transistors (4, 5) verbunden ist,
- wobei jede Abzweigung weiterhin ein Mittel aufweist, das einen Widerstand (8, 9; 18, 19; 18*, 19*) bildet, der mit einem der Stromterminals des Transistors (4, 5) verbunden ist,
wobei die ersten Transistoren (4, 5) der ersten und zweiten Abzweigung (10, 20) in Differentialkonfiguration angeschlossen sind, wobei das erste Stromterminal des ersten Transistors (4; 5) der ersten Abzweigung (10) beziehungsweise der zweiten Abzweigung (20) mit dem Steuerterminal des ersten Transistors (5; 4) der zweiten Abzweigung (20) beziehungsweise der ersten Abzweigung (10) verbunden ist, und
- ein kapazitives Element (7) zwischen den zweiten Stromterminals der ersten Transistoren (4, 5) der ersten und zweiten Abzweigung (10, 20),
**dadurch gekennzeichnet, dass** der Differentialoszillatorkreis weiterhin aufweist:
- einen elektromechanischen Volumenwellenresonator (6) wie einen Quarzresonator, wobei der Resonator nur durch eine erste und zweite Klemme (6a, 6b) zwischen den ersten Stromterminals der ersten Transistoren (4, 5) der ersten und zweiten Abzweigung (10, 20) verbunden ist, wobei die erste und zweite Klemme (6a, 6b) des elektromechanischen Resonators (6) eine erste und zweite Ausgangsklemme des Differentialoszillatorkreises bilden.

2. Differentialoszillatorkreis nach Anspruch 1, **dadurch gekennzeichnet, dass** die erste Stromquelle (2, 3) jeder Abzweigung (10, 20) zwischen dem zweiten Stromterminal des ersten Transistors (4, 5) und dem niedrigen Versorgungsterminal (VSS) verbunden ist,
und dass das einen Widerstand bildende Mittel ein resistives Element (8, 9) ist, das zwischen dem ersten Stromterminal des ersten Transistors (4, 5) und dem hohen Versorgungspotential (VDD) verbunden ist.

3. Differentialoszillatorkreis nach Anspruch 1, **dadurch gekennzeichnet, dass** die erste Stromquelle (2, 3) jeder Abzweigung (10, 20) zwischen dem zweiten Stromterminal des ersten Transistors (4, 5) und dem niedrigen Versorgungsterminal (VSS) verbunden ist,
und dass das einen Widerstand bildende Mittel ein zweiter Transistor (18*, 19*) ist, der ein Steuerterminal, ein erstes Stromterminal und ein zweites Stromterminal aufweist, die jeweils mit dem ersten Stromterminal des ersten Transistors (4, 5) über eine zweite Stromquelle (2*, 3*) oder mit dem zweiten Stromterminal des ersten Transistors (4, 5), dem hohen Versorgungspotential (VDD) und mit dem ersten Stromterminal des ersten Transistors (4, 5) über die zweite Stromquelle (2*, 3*) verbunden sind.

4. Differentialoszillatorkreis nach Anspruch 1, **dadurch gekennzeichnet, dass** die erste Stromquelle (2, 3) jeder Abzweigung (10, 20) zwischen dem zweiten Stromterminal des ersten Transistors (4, 5) und dem hohen Versorgungsterminal (VDD) verbunden ist,
und dass das einen Widerstand bildende Mittel ein zweiter Transistor (18, 19) ist, der ein Steuerterminal, ein erstes Stromterminal (18a, 19a) und ein zweites Stromterminal aufweist, die jeweils mit dem ersten Stromterminal des ersten Transistors (4, 5), mit dem zweiten Stromterminal des ersten Transistors (4, 5) und mit dem niedrigen Versorgungspotential (VSS) verbunden sind.

5. Differentialoszillatorkreis nach Anspruch 4, **dadurch gekennzeichnet, dass** er weiterhin eine mit den Klemmen des elektromechanischen Resonators (6) verbundene Amplitudenkontrollschleife (50) aufweist, um den von den ersten Stromquellen (2, 3) der ersten und zweiten Abzweigung (10, 20) gelieferten Strom zu regeln,
wobei diese Amplitudenkontrollschleife (50) zwei resistive Elemente (51, 52) aufweist, die in Reihe zwischen den Klemmen des elektromechanischen Resonators (6) gekoppelt sind und ein kapazitives Elemente (55), das zwischen dem Anschlussknoten der resistiven Elemente (51, 52) und dem niedrigen Versorgungspotential (VSS) gekoppelt ist, wobei die am Anschlussknoten der resistiven Elemente (51, 52) anliegende Spannung ein Regelungsmittel (65) des Stroms steuert, der von den ersten Stromquellen (2, 3) der ersten und zweiten Abzweigung (10,20) bereitgestellt wird.

6. Differentialoszillatorkreis nach Anspruch 5, **dadurch gekennzeichnet, dass** die ersten Stromquellen (2, 3) mit Hilfe eines Stromspiegels (60) umgesetzt sind, der eine Referenzabzweigung (61) umfasst und eine erste und zweite Ausgangsabzweigung (61, 62), die jeweils mit der ersten und zweiten Abzweigung (10, 20) des Oszillatorkreises verbunden sind,
und dass das Regelungsmittel (57) ein Transistor ist, der durch seine Stromterminals in der Referenzabzweigung (61) des Stromspiegels (60) in Reihe gekoppelt ist und dessen Steuerterminal mit dem Anschlussknoten der resistiven Elemente (51, 52) verbunden ist.

7. Differentialoszillatorkreis nach Anspruch 3, **dadurch gekennzeichnet, dass** das Steuerterminal des ersten Transistors (4; 5) der ersten Abzweigung (10) beziehungsweise der zweiten Abzweigung (20) mit dem ersten Stromterminal des ersten Transistors (5; 4) der zweiten Abzweigung (20) beziehungsweise der ersten Abzweigung (10) mit einem kapazitiven Element (11, 12) verbunden ist,
und dass jede Abzweigung (10, 20) des Differentialoszillatorkreises weiterhin ein resistives Element (13, 14) aufweist, das zwischen dem ersten Stromterminal und dem Steuerterminal des ersten Transistors (4, 5) verbunden ist.

8. Differentialoszillatorkreis nach Anspruch 3, **dadurch gekennzeichnet, dass** das Steuerterminal des ersten Transistors (4; 5) der ersten Abzweigung (10) beziehungsweise der zweiten Abzweigung (20) mit dem ersten Stromterminal des ersten Transistors (5; 4) der zweiten Abzweigung (20) beziehungsweise der ersten Abzweigung (10) mit einem kapazitiven Element (11, 12) verbunden ist,
und dass jede Abzweigung (10, 20) des Differentialoszillatorkreises weiterhin einen Verstärker (13*, 14*) aufweist, der eine erste und zweite Eingangsklemme aufweist, die jeweils mit dem ersten Stromterminal des ersten Transistors (4, 5) und mit einer Referenzspannung (Vref) verbunden sind, wobei der Ausgang des Verstärkers (13*, 14*) am Steuerterminal des ersten Transistors (4, 5) anliegt.

9. Differentialoszillatorkreis nach einem der vorangehenden Ansprüche, **dadurch gekennzeichnet, dass** der elektromechanische Resonator (6) ein Resonator mit hoher Impedanz im stufenlosen Betrieb ist.

10. Differentialoszillatorkreis nach einem der vorangehenden Ansprüche, **dadurch gekennzeichnet, dass** der elektromechanische Resonator (6) ein Resonator mit akustischen Volumenwellen ist.
